# EUROPÄISCHE PATENTSCHRIFT

(11) **EP 1 806 040 B1**
(45) Veröffentlichungstag und Bekanntmachung des Hinweises auf die Patenterteilung: **12.09.2012**
(21) Anmeldenummer: 05803373.9
(22) Anmeldetag: 24.10.2005
(51) Int. Cl.: G01F 15/00, H05K 5/06, H05K 7/14

(54) **GEHÄUSE MIT EINEM ANZEIGE- UND/ODER BEDIENELEMENT**
HOUSING WITH A DISPLAY ELEMENT AND/OR OPERATING ELEMENT
BOÎTIER POURVU D'UN ÉLÉMENT D'AFFICHAGE ET / OU DE COMMANDE

(30) Priorität: 28.10.2004 DE 102004052497
(43) Veröffentlichungstag der Anmeldung: 11.07.2007
(73) Patentinhaber: Endress+Hauser Flowtec AG, 4153 Reinach (CH)
(72) Erfinder: MOSER, Thiérry, F-68510 Sierentz (FR)
(74) Vertreter: Andres, Angelika Maria
(86) Internationale Anmeldenummer: PCT/EP2005/055491
(87) Internationale Veröffentlichungsnummer: WO 2006/045770

(56) Entgegenhaltungen:
- DE-A1- 3 406 295
- DE-A1- 4 341 239
- DE-A1- 19 646 583
- DE-A1- 19 755 924
- US-B1- 6 539 819

## Beschreibung

Die Erfindung betrifft ein Gehäuse mit einem Anzeige- und/oder Bedienelement für den Einsatz in explosionsgefährdeten Bereichen.

In der industriellen Messtechnik werden elektronische Geräte, insb. Messgeräte, regelmäßig an Orten eingesetzt, an denen die Gefahr einer Explosion besteht. Hier seien als Beispiel Mehlsilos, Tankstellen und Chemieanlagen, an denen explosive Gase auftreten können, genannt.

Häufig eingesetzte Messgeräte sind z.B. Durchflussmessgeräte, Füllstandsmessgeräte und Druckmessgeräte.

An Geräte, die in explosionsgefährdeten Bereichen einsetzbar sind, werden besondere Sicherheitsanforderungen gestellt. Diese haben das Ziel eine Funkenbildung, die ggf. eine Explosion auslösen könnte, zu vermeiden oder zu verhindern, dass ein im Inneren eines abgeschlossenen Raumes entstehender Funke Auswirkungen auf die Umgebung hat. Dieses Ziel ist auf verschiedene Arten, die in entsprechenden Europäischen Normen als Zündschutzarten bezeichnet sind, erreichbar.

So ist z.B. gemäß der Europäischen Norm EN 50 020 aus dem Jahr 1994 Explosionsschutz gegeben, wenn Geräte gemäß der darin definierten Schutzklasse mit dem Namen 'Eigensicherheit' (Ex-i) ausgebildet sind. Gemäß dieser Schutzklasse haben die Werte für die elektrischen Größen Strom, Spannung und Leistung in einem Gerät zu jeder Zeit jeweils unterhalb eines vorgegebenen Grenzwertes zu liegen. Die drei Grenzwerte sind so gewählt, dass im Fehlerfall, z.B. durch einen Kurzschluss, die maximal entstehende Wärme nicht ausreicht, um einen Zündfunken zu erzeugen. Der Strom wird z.B. durch Widerstände, die Spannung z.B. durch Zener-Dioden und die Leistung durch entsprechende Kombination von Strom und Spannung begrenzenden Elementen unter den vorgegebenen Grenzwerten gehalten.

Eine weitere unter der Bezeichnung 'Druckfeste Kapselung' (Ex-d) geführte Schutzklasse ist in der Europäischen Norm EN 50 018 aus dem Jahr 1994 beschrieben. Geräte die gemäß dieser Schutzklasse ausgebildet sind, weisen ein druckfestes Gehäuse auf, durch das sichergestellt ist, dass eine im Inneren des Gehäuses auftretende Explosion nicht in den Außenraum übertragen werden kann. Druckfeste Gehäuse sind, damit sie eine ausreichende mechanische Festigkeit aufweisen, dickwandig und damit schwer und teuer.

In den USA, in Kanada, in Japan und anderen Ländern gibt es mit diesen Europäischen Normen vergleichbare Standards.

Die Anforderungen des Explosionsschutzes gelten natürlich nicht nur für das eigentliche Messgerät selbst, sondern auch für Anzeige- und/oder Bedienelemente, die in explosionsgefährdeten Bereichen eingesetzt werden. Anzeigeelemente dienen z.B. dazu Messwerte vor Ort anzuzeigen. Über Bedienelemente können z.B. vor Ort Einstellungen am Gerät vorgenommen, oder Bedienparameter eingegeben werden.

Anzeige- und/oder Bedienelemente sind aus Explosionsschutzgründen heute häufig in Innenräumen des Gehäuses des Messgeräts oder in separaten Gehäuseteilen angeordnet, die z.B. mittels eines druckfesten Deckels verschlossen sind. Derartige Deckel weisen in der Regel ein Sichtfenster auf, das ein Ablesen der Anzeige ermöglicht. Es ist möglich, das Bedienelement mit optischen Tasten auszustatten, die durch das Sichtfenster hindurch bedient werden können. Kostengünstigere mechanische Tasten können durch den Deckel hindurch nicht bedient werden. Der Deckel stellt ein zusätzliches Bauteil dar, mit dem eine Erhöhung der Produktionskosten verbunden ist.

Es ist eine Aufgabe der Erfindung, ein Gehäuse mit einem Anzeige- und/oder Bedienelement anzugeben, das in explosionsgefährdeten Bereichen einsetzbar ist und kostengünstig herstellbar ist.

Hierzu besteht die Erfindung in einem Gehäuse

- mit einem Innenraum zur Aufnahme einer Elektronik,

- das außen eine Ausnehmung aufweist,

-- in der ein Anzeige- und/oder Bedienelement angeordnet ist,

--- dessen Anschlussleitungen über eine druckfeste Durchführung in den

Innenraum hineingeführt sind,

- bei dem das Anzeige- und/oder Bedienelement allseitig von einer

druckfesten, glasklaren Vergussmasse umgeben ist,

-- die in der Ausnehmung verbleibende Hohlräume ausfüllt und

-- die Ausnehmung nach außen verschließt.

Gemäß einer Weiterbildung ist die Durchführung ein metallischer Einsatz, der einen ersten Abschnitt aufweist, der in eine den Innenraum mit der Ausnehmung verbindende Gewindebohrung eingeschraubt ist.

Gemäß einer Weiterbildung der letztgenannten Weiterbildung weist die Durchführung einen an den ersten Abschnitt angrenzenden zweiten Abschnitt auf, der die Ausnehmung auskleidet, und der einen nach außen, in vom ersten Abschnitt abgewandter Richtung offenen Innenraum aufweist, in dem das Anzeige- und/oder Bedienelement angeordnet ist.

Gemäß einer weiteren Weiterbildung weist der erste Abschnitt an dessen ins Innere des Gehäuses weisenden Seite eine zum Innenraum hin offene Ausnehmung auf, in die ein druckfester Verguss, insb. ein Gießharz, eingebracht ist, der die Anschlussleitungen umgibt.

Gemäß einer weiteren Weiterbildung weist das Anzeige- und/oder Bedienelement optische Tasten auf, die durch den Verguss hindurch bedienbar sind.

Gemäß einer anderen Weiterbildung weist das Anzeige- und/oder Bedienelement mechanische Tasten auf, die über eine mittels einer Tastenabdeckung verschlossene Ausnehmung im Verguss bedienbar sind, und ist über im Gehäuse befindliche Strom und Spannung begrenzende Elemente gespeist.

Gemäß einer weiteren Weiterbildung ist das Anzeige- und/oder Bedienelement mit dem Einsatz verbunden und der Einsatz ist in eine gewünschte Position drehbar und mittels einer Befestigung fixierbar.

Gemäß einer weiteren Weiterbildung ist in eine äußere Nut des ersten Abschnitts ein Sicherungsring eingebracht.

Die Erfindung und weitere Vorteile werden nun anhand der Figuren der Zeichnung, in denen zwei Ausführungsbeispiele dargestellt sind, näher erläutert; gleiche Teile sind in den Figuren mit gleichen Bezugszeichen versehen.

Fig. 1 zeigt einen Schnitt durch ein gemäß der Schutzklasse Ex-d

ausgebildetes Gehäuse mit einem Anzeige- und/oder

Bedienelement mit optischen Tasten;

Fig. 2 zeigt einen Schnitt durch ein druckfestes Gehäuse mit einem Anzeige.

und/oder Bedienelement mit mechanischen Tasten; und

Fig. 3 zeigt eine Ansicht des in Fig. 2 dargestellten Anzeige- und/oder

Bedienelements.

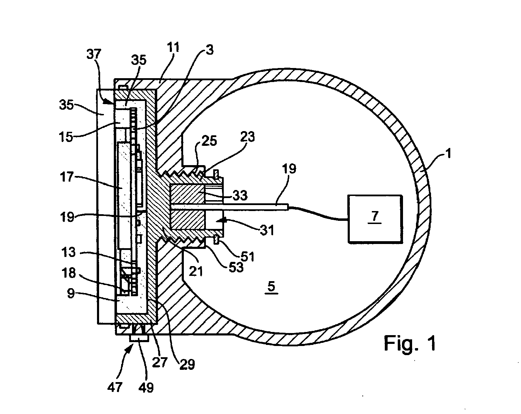

Fig. 1 zeigt einen Schnitt durch ein erstes Ausführungsbeispiel eines erfindungsgemäßen Gehäuses 1 mit einem Anzeige- und/oder Bedienelement 3.

Das Gehäuse 1 ist beispielsweise ein Gehäuse eines Messgeräts, z.B. eines Durchfluss-, Druck- oder Füllstandsmessgerät. Es weist einen Innenraum 5 zur Aufnahme einer Elektronik 7, z.B. einer in Fig. 1 lediglich schematisch dargestellten Messgerätelektronik, auf.

Das Gehäuse 1 besteht aus Metall, z.B. aus Aluminium, und ist druckfest ausgebildet. Hierdurch ist sichergestellt, dass eine im Inneren des Gehäuses auftretende Explosion nicht in den Außenraum übertragen werden kann. Entsprechend kann das Gehäuse 1 in explosionsgefährdeten Bereichen eingesetzt werden.

Das Gehäuse 1 weist außen eine Ausnehmung 9 auf, in der das Anzeige- und/oder Bedienelement 3 angeordnet ist. In dem dargestellten Ausführungsbeispiel wird die Ausnehmung 9 durch ein nach außen offenes an das Gehäuse 1 angeformtes hohlzylindrisches Element 11 gebildet.

Das Anzeige- und/oder Bedienelement 3 weist eine Leiterplatte 13 auf, auf der in dem dargestellten Ausführungsbeispiel sowohl Tasten 15 als auch ein Display 17 angeordnet sind. Tasten 15 und Display 17 sind unmittelbar auf die Leiterplatte 13 montiert und von einem ebenfalls auf der Leiterplatte 13 befestigten Kunststoffhalter 18 umgeben. Hierbei können sowohl konventionelle Leiterplatten als auch dreidimensionale gespritzte Schaltungen, so genannte

3 D MID's (3 Dimensional Molded Interconnection Devices) eingesetzt werden.

Das Anzeige- und/oder Bedienelement 3 weist Anschlussleitungen 19 auf, die über eine druckfeste Durchführung in den Innenraum 5 des Gehäuses 1 hineingeführt sind.

Die druckfeste Durchführung umfasst einen metallischen Einsatz 21, z.B. aus Stahl. Dieser weist einen ersten Abschnitt 23 auf, der in eine den Innenraum 5 mit der Ausnehmung 9 verbindende Gewindebohrung 25 eingeschraubt ist. Durch diese Verschraubung ist der Einsatz 21 außen druckfest mit dem Gehäuse 1 verbunden.

An den ersten Abschnitt 23 grenzt ein zweiter Abschnitt 27 an, der die Ausnehmung 9 auskleidet. Der zweite Abschnitt 27 weist einen nach außen, in vom ersten Abschnitt 23 abgewandter Richtung offenen Innenraum auf, in dem das Anzeige- und/oder Bedienelement 3 angeordnet ist. Der zweite Abschnitt 27 hat in dem dargestellten Ausführungsbeispiel die Form eines einseitig endseitig durch einen Boden 29 abgeschlossenen Hohlzylinders, dessen äußere Mantelflächen unmittelbar an den entsprechenden inneren Mantelflächen der Ausnehmung 9 anliegen.

Der erste Abschnitt 23 ist ein Vollzylinder, der an dessen ins Innere 5 des Gehäuses 1 weisenden Seite eine zum Innenraum 5 hin offene Ausnehmung 31 aufweist, durch die die Anschlussleitungen 19 hindurch geführt sind. Die Anschlussleitungen 19 sind in dem dargestellten Ausführungsbeispiel in einem Flachbandkabel zusammengefasst. In die Ausnehmung 31 ist ein druckfester Verguss 33, insb. ein Gießharz, wie z.B. Polyurethan, eingebracht, der die Anschlussleitungen 19 umgibt. Vorzugsweise wird ein Material mit einer Shore-Härte von 70 bis 80 verwendet. Durch die Druckfestigkeit des Vergusses 33 ist die Druckfestigkeit der Durchführung gewährleistet.

Das Anzeige- und/oder Bedienelement 3 ist allseitig von einem druckfesten, glasklaren Verguss 35 umgeben. Hierzu eignet sich z.B. ein Epoxidharz oder ein Polyurethan. Auch hier wird vorzugsweise ein Material mit einer Shore-Härte von 70 bis 80 verwendet. Der Verguss 35 füllt in der Ausnehmung 9 verbleibende Hohlräume aus und verschließt die Ausnehmung 9 nach außen.

Aus Gründen der elektromagnetischen Verträglichkeit ist das Anzeige- und/oder Bedienelement 3 vorzugsweise mit einer elektrisch leitfähigen Schicht 37 überdeckt, die elektrisch mit dem Einsatz 21 und dem Gehäuse 1 verbunden ist. Die leitfähige Schicht 37 besteht z.B. aus einem leitfähigem Film oder einem Blechstanzteil, und weist Ausnehmungen auf, die die Tasten 15 und das Display 17 freigeben.

In dem dargestellten Ausführungsbeispiel schließt die leitfähige Schicht 37 die Ausnehmung 9 frontbündig ab und ist mit einer hier ringscheibenförmige Stirnfläche des Einsatzes 21 elektrisch leitend verbunden. Durch den unmittelbaren Kontakt zwischen dem Einsatz 21 und dem Gehäuse 1 besteht zugleich eine elektrisch leitende Verbindung zum Gehäuse 1. Außerhalb der leitfähigen Schicht 37 befindet sich eine hier kreisscheibenförmige Schicht des Vergusses 35. Deren Außendurchmesser ist gleich dem Außendurchmesser des Einsatzes 21. Dies bietet den Vorteil, dass das Anzeige- und/oder Bedienelement 3 in dem Einsatz 21 vormontiert und mit Verguss 35 umgeben werden kann und die so gebildete Einheit anschließend in das Gehäuse 1 eingebaut werden kann.

Bei der Herstellung wird der Einsatz 21 mit dem Anzeige- und Bedienelement 3 bestückt und dessen Anschlussleitungen 19 durchgeführt. Anschließend wird die leitfähige Schicht 37 montiert und die auf diese Weise gebildete Einheit in ein entsprechendes Formteil eingebracht und vergossen. Nach dem Aushärten des Vergusses 35 bildet dieser einen druckfesten Verschluss.

Weitere Bauelemente, wie z.B. im Stand der Technik regelmäßig verwendete gemäß den Vorschriften des Explosionsschutzes auszubildende druckfeste Glasdeckel, sind zum Verschluss des Gehäuses 1 und/oder des Anzeige- und/oder Bedienelementes 3 nicht erforderlich. Hierdurch wird erreicht, dass die Herstellungskosten gegenüber dem Stand der Technik deutlich reduziert sind.

Bei dem in Fig. 1 dargestellten Ausführungsbeispiel sind die Tasten 15 optische Tasten, die durch den darüber befindlichen glasklaren Verguss 35 hindurch bedienbar sind.

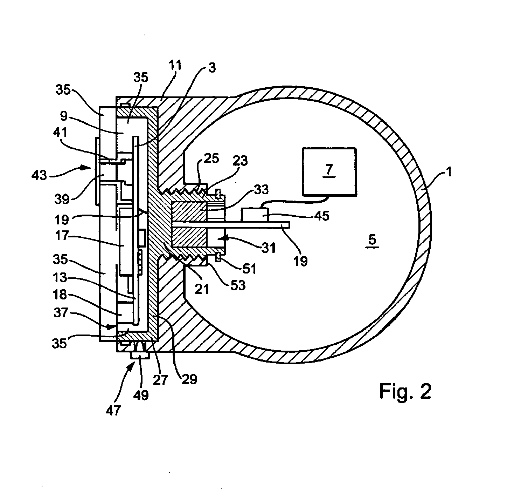

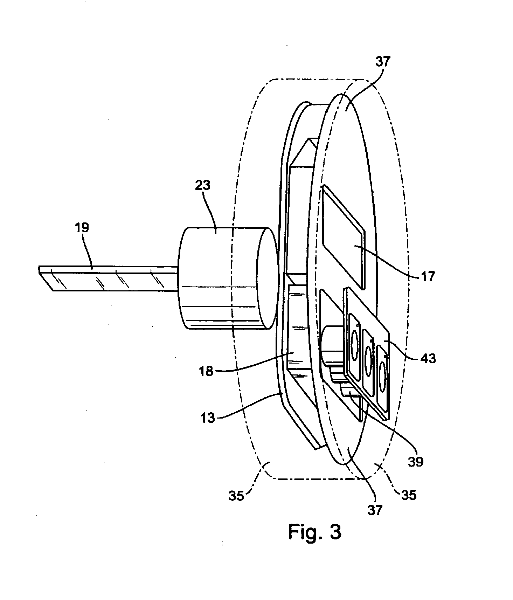

Alternativ sind auch kostengünstigere mechanische Tasten 39 einsetzbar. Fig. 2 zeigt einen Schnitt durch ein druckfestes Gehäuse 1 mit einem Anzeige- und/oder Bedienelement 3 mit mechanischen Tasten 39. Fig. 3 zeigt eine Ansicht des in Fig. 2 dargestellten Anzeige- und/oder Bedienelements. Aufgrund der großen Übereinstimmung zu dem in Fig. 1 dargestellten Ausführungsbeispiel werden nachfolgend lediglich die bestehenden Unterschiede näher erläutert. Diese ergeben sich daraus, dass anstelle der in Fig. 1 dargestellten optischen Tasten 15 hier mechanische Tasten 39 vorgesehen sind. Für jede mechanische Taste 39 besteht eine Ausnehmung 41 im Verguss 35 durch die die Tasten 39 freigelegt sind. Die Tasten 39 schließen frontbündig mit dem Verguss 35 ab. Von Außen sind die Ausnehmungen 41 und ein diese umgebender Bereich des Vergusses 35 mit einer Tastenabdeckung 43 verschlossen. Die Tastenabdeckung 43 ist z.B. eine Schicht aus einem Elastomer, die auf den Verguss 35 aufgeklebt ist. Durch die Ausnehmungen 41 ist die druckfeste Kapselung des Anzeige - und/oder Bedienelements 3 in diesem Bereich unterbrochen. Auf der von den Tasten 39 abgewandten Seite der Leiterplatte 3 besteht durch den zwischen dem Boden 29 des Einsatzes 21 und der Leiterplatte 3 befindlichen Verguss 35 jedoch genau wie bei dem in Fig. 1 dargestellten Ausführungsbeispiel ein druckfester Verschluss.

Die Versorgung des Anzeige- und/oder Bedienelements 3 erfolgt über im Inneren des Gehäuses 1 befindliche Strom und Spannung begrenzende Elemente 45 vorzugsweise gemäß der eingangs beschriebenen Schutzklasse Ex-i. Ist der Innenraum des Gehäuses 1 druckfest gekapselt, so genügt es hierzu die Strom und Spannung begrenzenden Elemente 45 zwischen die Elektronik 7 und die Anschlussleitungen 19 zu schalten. Ist die gesamte im Inneren des Gehäuses 1 befindliche Elektronik 7 bereits gemäß des Schutzklasse Ex-i ausgebildet, so kann auf die Strom und Spannung begrenzenden Elemente 45 verzichtet werden.

Der Einsatz 21 ist in die Gewindebohrung 25 eingeschraubt. Diese Schraubverbindung bietet den Vorteil, dass der Einsatz 21 und damit das damit verbundene Anzeige- und/oder Bedienelement 3 in eine gewünschte Position gedreht werden kann. Befindet sich der Einsatz 21 in der gewünschten Position, wird er vorzugsweise mittels einer Befestigung 47, die eine weitere Drehung verhindert, fixiert. Hierzu eignen sich z.B. in den Figuren 1 und 2 dargestellte Fixierstifte 49, die jeweils durch eine Gewindebohrung im hohlzylindrischen Element 11 hindurch gegen den Einsatz 21 geschraubt werden.

Vorzugsweise ist zusätzlich ein Sicherungselement vorgesehen, dass sicherstellt, dass der Einsatz 21 beim Einstellen der gewünschten Postion nicht zu weit heraus geschraubt wird. Bei den meisten Anwendungen genügt eine Gewindelänge von ca. 15 mm, um eine ausreichende Druckfestigkeit zu gewährleisten. Diese, in der Regel durch nationale Vorschriften vorgegebene, Gewindelänge darf nicht unterschritten werden. In den dargestellten Ausführungsbeispielen ist als Sicherungselement ein Sicherungsring 51 vorgesehen, der in eine äußere Nut im ersten Abschnitt 23 eingebracht ist. Aufgrund des Sicherungsringes 51 kann der Einsatz 11 nur soweit heraus geschraubt werden, bis der Sicherungsring 51 an einer an die Gewindebohrung 25 angrenzenden Mantelfläche 53 aufliegt.

## Patentansprüche

1. Gehäuse (1) - für den Einsatz in explosionsgefährdeten Bereichen mit einem Innenraum (5) zur Aufnahme einer Elektronik (7), - das außen eine Ausnehmung (9) aufweist, -- in der ein Anzeige- und/oder Bedienelement (3) angeordnet ist, --- dessen Anschlussleitungen (19) über eine druckfeste Durchführung in den Innenraum (5) hineingeführt sind; - bei dem das Anzeige- und/oder Bedienelement (3) allseitig von einem druckfesten, glasklaren Verguss (35) umgeben ist, -- der in der Ausnehmung (9) verbleibende Hohlräume ausfüllt und -- die Ausnehmung (9) nach außen verschließt.

2. Gehäuse (1) nach Anspruch 1, bei dem die Durchführung ein metallischer Einsatz (21) ist, der einen ersten Abschnitt (23) aufweist, der in eine den Innenraum (5) mit der Ausnehmung (9) verbindende Gewindebohrung (25) eingeschraubt ist.

3. Gehäuse (1) nach Anspruch 2, bei dem die Durchführung einen an den ersten Abschnitt (23) angrenzenden zweiten Abschnitt (27) aufweist, - der die Ausnehmung (9) auskleidet, und - der einen nach außen, in vom ersten Abschnitt (23) abgewandter Richtung offenen Innenraum aufweist, in dem das Anzeige - und/oder Bedienelement (3) angeordnet ist.

4. Gehäuse (1) nach Anspruch 2, bei dem der erste Abschnitt (23) an dessen ins Innere des Gehäuses (1) weisenden Seite eine zum Innenraum (5) hin offene Ausnehmung (31) aufweist, in die ein druckfester Verguss (33), insb. ein Gießharz, eingebracht ist, der die Anschlussleitungen (19) umgibt.

5. Gehäuse (1) nach Anspruch 1, bei dem das Anzeige- und/oder Bedienelement 3 optische Tasten (15) aufweist, die durch den Verguss (35) hindurch bedienbar sind.

6. Gehäuse (1) nach Anspruch 1, bei dem das Anzeige- und/oder Bedienelement (3) mechanische Tasten (3) aufweist, die über eine mittels einer Tastenabdeckung (43) verschlossene Ausnehmung (41) im Verguss (35) bedienbar sind, und über im Gehäuse 1 befindliche Strom und Spannung begrenzende Elemente (45) gespeist ist.

7. Gehäuse (1) nach Anspruch 2, bei dem das Anzeige- und/oder Bedienelement (3) mit dem Einsatz (21) verbunden ist und der Einsatz (21) in eine gewünschte Position drehbar und mittels einer Befestigung (47) fixierbar ist.

8. Gehäuse (1) nach Anspruch 1 oder 7, bei dem in eine äußere Nut des ersten Abschnitts (23) ein Sicherungsring (51) eingebracht ist.

## Claims

1. Housing (1), for use in hazardous areas, with an interior area (5) designed to house electronics (7) - which has a recess on the outside (9), -- in which a display element and/or an operating element (3) is arranged, --- whose connection cables (19) lead into the interior area (5) via a flameproof feedthrough; where the display element and/or operating element (3) is surrounded on all sides by a flameproof transparent compound (35), -- which fills in remaining cavities in the recess (9) and -- which seals the recess (9) to the outside.

2. Housing (1) as claimed in Claim 1, where the feedthrough is a metal insert (21) which has a first section (23) which is screwed into a threaded borehole (25) which connects the interior area (5) with the recess (9).

3. Housing (1) as claimed in Claim 2, where the feedthrough (9) has a second section (27) which is adjacent to the first section (23), - which lines the recess (9) and - which has an interior which is open to the outside in the direction facing away from the first section (23), in which the display unit and/or operating unit (3) is arranged.

4. Housing (1) as claimed in Claim 2, where the first section (23) has a recess (31) which is open to the interior area (5) on the side facing towards the inside of the housing (1) in which a flameproof compound (31), particularly a casting resin, is installed which surrounds the connection cables (19).

5. Housing (1) as claimed in Claim 1, where the display element and/or operating element (3) has optical keys (15) which can be operated through the compound (35).

6. Housing (1) as claimed in Claim 1, where the display element and/or operating element (3) has mechanical keys (3) which can be operated via a recess (41) in the compound (35) which is sealed by a key cover (43), and is powered by elements (45) that limit current and voltage and are located in the housing (1).

7. Housing (1) as claimed in Claim 2, where the display element and operating element (3) is connected to the insert (21) and the insert (21) can be turned to a desired position and can be fixed with a securing unit (47).

8. Housing (1) as claimed in Claim 1 or 7, where a circlip (51) is installed in an outer groove of the first section (23).

## Revendications

1. Boîtier (1) avec un intérieur (5) destiné au logement d'une électronique (7), qui présente à l'extérieur un évidement (9), -- dans lequel est disposé un élément d'affichage et/ou de commande (3), --- dont les lignes de raccordement (19) sont acheminées à l'intérieur (5) par l'intermédiaire d'une traversée résistant à la pression ; pour lequel l'élément d'affichage et/ou de commande (3) est entouré de tous côtés par une masse de scellement (35) transparente, résistant à la pression, -- qui remplit les cavités restantes dans l'évidement (9) et -- qui obture l'évidement (9) vers l'extérieur.

2. Boîtier (1) selon la revendication 1, pour lequel la traversée est un insert métallique (21), qui présente une première partie (23), laquelle est vissée dans un trou taraudé (25) reliant l'intérieur (5) avec l'évidement (9).

3. Boîtier (1) selon la revendication 2, pour lequel l'évidement (9) présente une deuxième partie (27), contiguë à la première partie (23), - qui revêt l'évidement (9) et - qui présente un intérieur ouvert situé à l'opposé de la première partie (23), dans lequel est disposé l'élément d'affichage et/ou de commande (3).

4. Boîtier (1) selon la revendication 2, pour lequel la première partie (23) présente sur son côté faisant face à l'intérieur du boîtier (1) un évidement (31) ouvert en direction de l'intérieur (5), dans lequel est coulée une masse de scellement (33) résistant à la pression, notamment une résine de coulée, laquelle entoure les lignes de raccordement (19).

5. Boîtier (1) selon la revendication 1, pour lequel l'élément d'affichage et/ou de commande (3) présente des touches optiques (15), qui sont utilisables à travers la masse de scellement (35).

6. Boîtier (1) selon la revendication 1, pour lequel l'élément d'affichage et/ou de commande (3) présente des touches mécaniques (39), qui sont utilisables par le biais d'un évidement (41) dans la masse de scellement (35), lequel évidement est obturé par un couvre-touche (43), et est alimenté au moyen d'éléments (46) limiteurs de courant et de tension se trouvant dans le boîtier (1).

7. Boîtier (1) selon la revendication 2, pour lequel l'élément d'affichage et/ou de commande (3) est relié avec l'insert (21) et pour lequel l'insert (21) peut être pivoté dans une position souhaitée et peut être fixé au moyen d'une fixation (47).

8. Boîtier (1) selon la revendication 1 ou 7, pour lequel un circlips (51) est logé dans la rainure extérieure de la première partie (23).
